# EUROPEAN PATENT APPLICATION

(11) **EP 3 629 384 A1**
(43) Date of publication of application: **01.04.2020**
(21) Application number: 19173323.7
(22) Date of filing: 08.05.2019
(51) Int. Cl.: H01L 31/02, H01L 31/042, H01L 31/05

(54) **SOLAR MODULES AND METHODS OF FORMING SOLAR MODULES**

(30) Priority: 28.09.2018 CN 201811139591
(71) Applicant: Flex, Ltd., Singapore 486123 (SG)
(72) Inventor: ZHOU, Lisong, Freemont, CA 94539 (US); ZHOU, Huaming, Wuxi Jiangsu (CN)
(74) Representative: v. Bezold & Partner Patentanwälte - PartG mbB

(57) **Abstract**

Methods of forming a solar module including a shingled array of solar cells are described including the steps of a) attaching a first electrically conductive bus ribbon to a first strip of a solar cell to form a first end strip solar cell, b) connecting at least one middle strip to the first end strip solar cell in a shingled configuration, c) connecting a second strip to the at least one middle strip to form a string of shingled strips, and d) attaching a second electrically conductive bus ribbon to the second strip to form a second end strip solar cell. Methods of forming a shingled array of solar cells are described including the steps of a) attaching a first electrically conductive bus ribbon to a distal end portion of a first strip of a solar cell to form a first end strip, b) attaching a second electrically conductive bus ribbon to a proximal end portion of a second strip of a solar cell to form a second end strip, c) connecting at least one middle strip to a proximal end portion of the first end strip in a shingled configuration, d) connecting a distal end portion of the second end strip to the at least one middle strip to form a string of shingled strips.

## Description

### Technical Field

The present disclosure relates to solar modules, and more particularly, to solar cells incorporated into shingled array module ("SAM"). Methods of forming a solar module including a shingled array of solar cells and methods of bonding strips of solar cells in a shingled configuration to form a string of solar cells in a shingled array are also provided.

### Background

Over the past few years, the use of fossil fuels as an energy source has been trending downward. Many factors have contributed to this trend. For example, it has long been recognized that the use of fossil fuel-based energy options, such as oil, coal, and natural gas, produces gases and pollution that may not be easily removed from the atmosphere. Additionally, as more fossil fuel-based energy is consumed, more pollution is discharged into the atmosphere causing harmful effects on life close by. Despite these effects, fossil-fuel based energy options are still being depleted at a rapid pace and, as a result, the costs of some of these fossil fuel resources, such as oil, have risen. Further, as many of the fossil fuel reserves are located in politically unstable areas, the supply and costs of fossil fuels have been unpredictable.

Due in part to the many challenges presented by these traditional energy sources, the demand for alternative, clean energy sources has increased dramatically. To further encourage solar energy and other clean energy usage, some governments have provided incentives, in the form of monetary rebates or tax relief, to consumers willing to switch from traditional energy sources to clean energy sources. In other instances, consumers have found that the long-term savings benefits of changing to clean energy sources have outweighed the relatively high upfront cost of implementing clean energy sources.

One form of clean energy, solar energy, has risen in popularity over the past few years. Advancements in semiconductor technology have allowed the designs of solar modules and solar panels to be more efficient and capable of greater output. Further, the materials for manufacturing solar modules and solar panels have become relatively inexpensive, which has contributed to the decrease in costs of solar energy. As solar energy has increasingly become an affordable clean energy option for individual consumers, solar module and panel manufacturers have made available products with aesthetic and utilitarian appeal for implementation on residential structures. As a result of these benefits, solar energy has gained widespread global popularity.

To date, solar cells are used as the building block of solar modules, including solar panels. A solar cell is made up of a substrate configured to be capable of producing energy by converting light energy into electricity. The substrate may be a photovoltaic material. Examples of suitable photovoltaic material include, but are not limited to, those made from multicrystalline or monocrystalline silicon wafers. These wafers may be processed through the major solar cell processing steps, which include wet or dry texturization, junction diffusion, silicate glass layer removal and edge isolation, silicon nitride anti-reflection layer coating, front and back metallization. The wafers may be further processed through advanced solar processing steps, including adding rear passivation coating and selective patterning to thereby obtain a passivated emitter rear contact (PERC) solar cell, which has a higher efficiency than solar cells formed using the standard process flow mentioned above. The solar cell may be a p-type monocrystalline cell or an n-type monocrystalline cell in other embodiments. Similar to the diffused junction solar cells described as above, other high efficiency solar cells, including heterojunction solar cells, can utilize the same metallization patterns in order to be used for the manufacture of a shingled array module. The solar cell may have a substantially square shape with chamfered corners (a pseudo-square) or a full square shape.

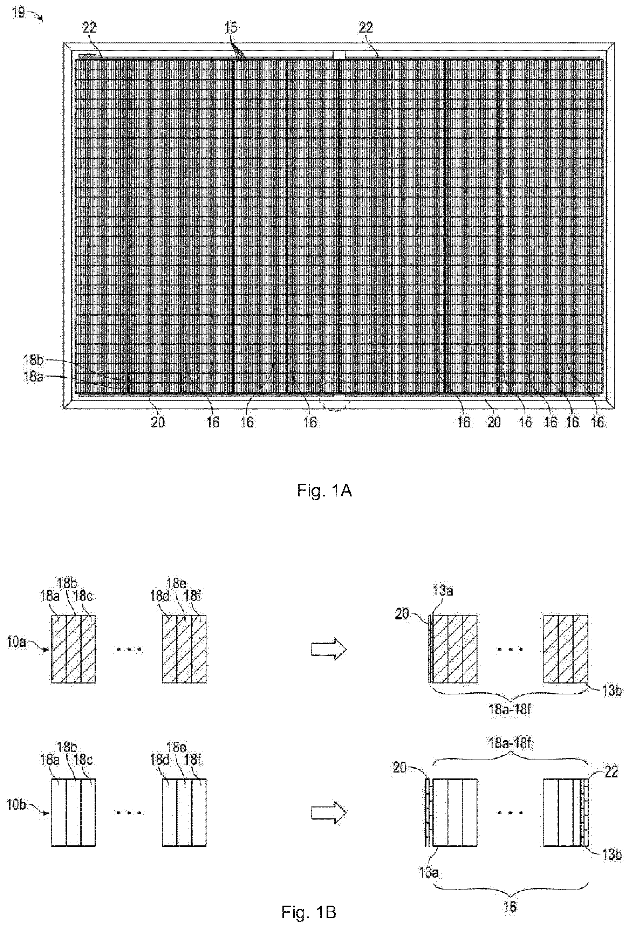

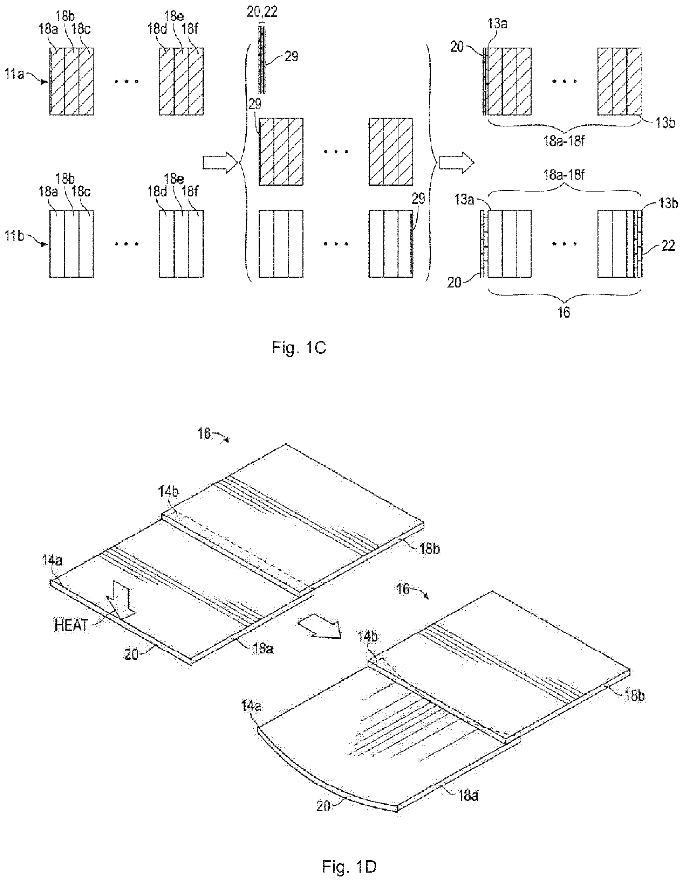

As shown in Fig. 1A, a solar module 19 can be formed to include an array of shingled strings 16 of solar cells 18a, 18b, each string 16 (larger first area emphasized in bold) including a plurality of solar cells 18a, 18b formed as strips (second smaller area emphasized in bold) Each neighboring strip 18a, 18b are connected in an overlapping or shingled configuration. As further depicted in Fig. 1A, each string 16 includes an electrically conductive bus ribbon 20, 22 positioned on opposite end portions, i.e., proximal end portion 14a and distal end portion 14b, of the string 16. The electrically conductive bus ribbons are designed to carry the electric output produced by the string(s) 16 of shingled solar cells 18a, 18b .

In the prior art, the bus ribbons 20, 22 are attached to the opposite ends of the string(s) 16 after formation of the string(s) 16. Figs. 1B and 1C depict methods found in the prior art wherein the string(s) 16 of shingled solar cells 18a-18f is formed prior to the attachment of the conductive bus ribbons 20, 22 via soldering, whereby the bus ribbons 20, 22 are adhered to the metalization pattern on the solar cells 18a-18f by the cooling of the molten solder. All other solar cells 18a-18f are adhered together using an electrically conductive adhesive (ECA).

Specifically, a top view 10a, 11a and a bottom view 10b, 11b of such methods are illustrated in each of Figs. 1B and 1C, wherein a plurality of strips of solar cells 18a-18f (without an electrically conductive bus ribbon) are initially connected together in a shingled configuration (e.g., using ECA). A first electrically conductive bus ribbon 20 and a second electrically conductive bus ribbon 22 are then soldered to the end solar cells 18a and 18f, after formation of the shingled configuration of solar cells 18a-f . Specifically, the first bus ribbon 20 is added to a first end portion 13a of the shingled configuration and the second bus ribbon 22 is added to a second end portion 13b of the shingled configuration of strips 18a-f of solar cells to form a string 16. The first end portion 13a being opposite second end portion 13b on string 16.

As shown in Fig. ID, attachment of the first bus ribbon 20 to a first end portion 14a of solar cell 18a can cause the first end portion 14a and/or the first bus ribbon 20 to deform, i.e., bend and/or curve, which can cause stress across the solar cell 18a. This bending or curving is caused by the different thermodynamic properties of the materials, specifically the silicon of the solar cell 18a and the metal foil of bus ribbon 20. As further shown in Fig. ID, because the strips 18a, 18b are connected to each other in a shingled configuration prior to the attachment of the bus ribbon 20, deformation of the first end portion 14a and/or the first bus ribbon 20 can also cause at least a portion of overlapping area 14b, i.e., the portion wherein shingled first and second strips 18a, 18b were previously connected, to deform. Deformation of the first solar cell 18a results in poor connectivity of the solar cell 18a to other components of the solar module 19. Further the stresses induced in the solar cell 18a as a result of this deformation can also create cracks and/or microcracks within the solar cell 18a and/or to the bonds between the neighboring solar cells 18b along overlapping area 14b. Deformation, cracks and/or microcracks can create gaps in the electrical connection between the solar cells 18a, 18b of string 16 and reduce the efficiency of the string, create hot spots in the solar module, or result in open electrical circuits of the solar module which prevent the solar cells from conducting the electrical power to neighboring strings 16 of solar cells.

The present disclosure seeks to address the aforementioned shortcomings of the current technology.

### Summary

The present disclosure provides solar modules and/or solar cells including electrically conductive bus ribbons bonded to the end portions of a string of shingled solar cells, each string including strips of solar cells. Methods of forming such solar modules and methods of bonding such strings and/or strips of solar cells in a shingled configuration are also described herein.

In some embodiments, methods of forming a solar module including a shingled array of solar cells are described including the steps of a) attaching a first electrically conductive bus ribbon to a first strip of a solar cell to form a first end strip solar cell, b) connecting at least one middle strip to the first end strip solar cell in a shingled configuration, c) connecting a second strip to the at least one middle strip to form a string of shingled strips, and d) attaching a second electrically conductive bus ribbon to the second strip to form a second end strip solar cell.

In some embodiments, the first electrically conductive bus ribbon may be soldered to the first strip.

In some embodiments, the first electrically conductive bus ribbon may be adhered to the first strip via an adhesive. In certain embodiments, the adhesive may be an electrically conductive adhesive.

In some embodiments, the first electrically conductive bus ribbon is attached to a back side of the first strip. In some embodiments, the first electrically conductive bus ribbon attached to the back side of the first strip is visible from a top side of the first strip and/or the string of shingled strips. In some embodiments, the first electrically conductive bus ribbon is not visible from a top side of the first strip and/or the string of shingled strips.

In some embodiments, the second electrically conductive bus ribbon may be soldered to the second strip.

In some embodiments, the second electrically conductive bus ribbon may be adhered to the second strip via an adhesive. In certain embodiments, the adhesive may be an electrically conductive adhesive.

In some embodiments, the first electrically conductive bus ribbon is attached to the first strip in the same manner that the second electrically conductive ribbon is attached to the second strip. In certain embodiments, the first bus ribbon and the second bus ribbon are soldered to the first strip and the second strip, respectively. In certain embodiments, the first bus ribbon and the second bus ribbon are adhered to the first strip and the second strip, respectively.

In some embodiments, the first electrically conductive bus ribbon is attached to the first strip in a different manner than the second electrically conductive ribbon is attached to the second strip. In some embodiments, the first bus ribbon is soldered to the first strip and the second bus ribbon is adhered to the second strip. In some embodiments, the first bus ribbon is adhered to the first strip and the second bus ribbon is soldered to the second strip.

In some embodiments, the second electrically conductive bus ribbon is attached to a back side of the second strip. In certain embodiments, the second electrically conductive bus ribbon attached to the back side of the second strip is visible from a top side of the second strip and/or the string of shingled strips. In certain embodiments, the second electrically conductive bus ribbon is not visible from a top side of the second strip and/or the string of shingled strips.

In some embodiments, the methods described herein may further include the step of positioning at least one first straightening fixture on at least one of a top side or bottom side of the first end strip, prior to connecting the first end strip to a first middle strip. The at least one first straightening fixture remaining removable from the first end strip prior to or at the completion of forming the string of shingled strips.

In some embodiments, methods of forming a shingled array of solar cells are described herein including the steps of a) attaching a first electrically conductive bus ribbon to a distal end portion of a first strip of a solar cell to form a first end strip, b) attaching a second electrically conductive bus ribbon to a proximal end portion of a second strip of a solar cell to form a second end strip, c) connecting at least one middle strip to a proximal end portion of the first end strip in a shingled configuration, d) connecting a distal end portion of the second end strip to the at least one middle strip to form a string of shingled strips.

In some embodiments, solar modules are described including at least one string including an array of shingled strips of solar cells and at least one first electrically conductive bus ribbon having a secured edge which is connected to a first end of the string and a free outer edge including slots, the slots extending inwardly from the free outer edge in a direction towards the secured edge.

Furthermore, the present disclosure includes the following further aspects and embodiments:

According to an first aspect a method of forming a shingled array of strips of solar cells is provided, comprising the steps of: a) attaching a first electrically conductive bus ribbon to a first strip of a solar cell to form a first end strip solar cell, b) connecting at least one middle strip to the first end strip solar cell in a shingled configuration, c) connecting a second strip to the at least one middle strip to form a string of shingled strips, d) attaching a second electrically conductive bus ribbon to the second strip to form a second end strip solar cell.

According to another aspect depending on the first aspect the attaching of step a) may include soldering of the first electrically conductive bus ribbon to the first strip and/or adhering of the first electrically conductive bus ribbon to the first strip via an adhesive.

According to another aspect depending on the first aspect the first electrically conductive bus ribbon of step a) may be attached to a back side of the first strip.

According to another aspect depending on the afore-mentioned aspect the first electrically conductive bus ribbon may be visible from a top side of the string of shingled strips. Alternatively, the first electrically conductive bus ribbon may not be visible from a top side of the string of shingled strips.

According to another aspect depending on the first aspect the attaching of step d) may include soldering of the second electrically conductive bus ribbon to the second strip.

According to another aspect depending on the first aspect the attaching of step d) may include adhering of the second electrically conductive bus ribbon to the second strip via adhesive.

According to another aspect depending on the first aspect the second electrically conductive bus ribbon may be visible from a top side of the string of shingled strips.

According to another aspect depending on the first aspect the method may further comprise a step of positioning a first straightening fixture on at least one side of the first strip prior to step a) to prevent deformation of the first strip or the first electrically conductive bus ribbon during step a).

According to another aspect depending on the first aspect the method may further comprise a step of positioning a first straightening fixture on at least one side of the first end strip solar cell prior to step b) to prevent deformation of at least one of the first end strip solar cell or the first electrically conductive bus ribbon during step b).

According to another aspect depending on the afore-mentioned aspect the first straightening fixture may be positioned on a top side of the first end strip solar cell.

According to a second aspect a method of forming a shingled array of solar cells is provided, comprising the steps of: a) attaching a first electrically conductive bus ribbon to a distal end portion of a first strip of a solar cell to form a first end strip solar cell, b) attaching a second electrically conductive bus ribbon to a proximal end portion of a second strip of solar cells to form a second end strip solar cell, c) connecting at least one middle strip to a proximal end portion of the first end strip solar cell in a shingled configuration, d) connecting a distal end portion of the second end strip solar cell to the at least one middle strip to form a string of shingled strips.

According to another aspect depending on the second aspect the attaching of step a) may include soldering of the first electrically conductive bus ribbon to the first strip and/or adhering of the first electrically conductive bus ribbon to the first strip via an adhesive.

According to another aspect depending on the second aspect the first electrically conductive bus ribbon may be visible from a top side of the string of shingled strips. Alternatively the first electrically conductive bus ribbon may not be visible from a top side of the string of shingled strips.

According to another aspect depending on the second aspect the attaching of step b) may include soldering of the second electrically conductive bus ribbon to the second strip and/or adhering of the second electrically conductive bus ribbon to the second strip via adhesive.

According to another aspect depending on the second aspect the second electrically conductive bus ribbon may be visible from a top side of the string of shingled strips.

According to another aspect depending on the second aspect the method may further comprise the step of positioning a first straightening fixture on at least one side of the first end strip solar cell prior to step c) to prevent deformation of at least one of the first end strip solar cell or the first electrically conductive bus ribbon during step c).

According to another aspect depending on the afore-mentioned aspect the first straightening fixture may be positioned on a top side of the first end strip solar cell.

According to another aspect depending on the second aspect the method may further comprise the step of positioning a second straightening fixture on a top side of the second end strip solar cell prior to step d) to prevent deformation of at least one of the second end strip solar cell or the second electrically conductive bus ribbon during step d).

According to another aspect depending on the afore-mentioned aspect the second straightening fixture may be further positioned on a bottom side of the second end strip solar cell.

According to a third aspect a solar module is provided, including at least one string including an array of shingled strips of solar cells and at least one first electrically conductive bus ribbon having a secured edge which is connected to a first end of the string and a free outer edge including slots, the slots extending inwardly from the free outer edge in a direction towards the secured edge.

According to another aspect depending on the third aspect the slots may include a longitudinal axis which is generally perpendicular to a longitudinal axis of the bus ribbon.

According to another aspect depending on the third aspect the first conductive bus ribbon may further include perforations positioned along the secured edge of the bus ribbon.

According to another aspect depending on the afore-mentioned aspect the slots may be a different shape than the perforations.

According to another aspect depending on the third aspect the solar module may further comprise at least one second electrically conductive bus ribbon having a secured edge which is connected to a second end of the string and a free outer edge including slots, the slots extending inwardly from the free outer edge in a direction towards the secured edge of the second bus ribbon.

According to a fourth aspect a method of forming a shingled array of strips of solar cells is provided, comprising the steps of: a) attaching a first edge of a first electrically conductive bus ribbon to a first strip of a solar cell to form a first end strip solar cell, wherein a free outer edge of the first electrically conductive bus ribbon includes slots extending inwardly from the free outer edge in a direction towards the first edge of the first electrically conductive bus ribbon, b) connecting at least one middle strip to the first end strip solar cell in a shingled configuration, c) connecting a second strip to the at least one middle strip to form a string of shingled strips, d) attaching a second electrically conductive bus ribbon to the second strip to form a second end strip solar cell.

According to another aspect depending on the fourth aspect the slots may be added to the first electrically conductive bus ribbon prior to attaching of the first electrically conductive bus ribbon of step a).

According to another aspect depending on the fourth aspect the slots may be added to the first electrically conductive bus ribbon after attaching of the first electrically conductive bus ribbon of step a).

### Brief Description of the Drawings

Various aspects of the present disclosure are described hereinbelow with reference to the drawings, which are incorporated in and constitute a part of this specification, wherein:
Fig. 1A is top view of a solar module including an array of shingled solar cells and electrically conductive bus ribbons;
Figs. 1B and 1C each depict a top and bottom view of a flow diagram of a method of forming solar modules found in the prior art;
Fig. 1D is perspective view of an end portion of shingled solar cells including the addition of an electrically conductive bus ribbon, as described herein;
Fig. 2A depicts a flow diagram of methods of forming a shingled array of solar cells and/or methods of bonding shingled solar cells as described in at least one embodiment herein;
Fig. 2B is a top view of an end strip solar cell including a straightening fixture positioned thereto as described in at least one embodiment herein;
Fig. 2C is a perspective view of an end strip solar cell as described in at least one embodiment herein;
Fig. 3 is a diagram of a plurality of first and second end solar cells each including an electrically conductive ribbon as described in at least one embodiment herein;
Figs. 4A and 4B each depict a flow diagram of methods of forming a shingled array of solar cells and/or methods of bonding shingled solar cells as described in at least one embodiment herein;
Figs. 5A and 5B each depict a flow diagram of methods of forming a shingled array of solar cells and/or methods of bonding shingled solar cells as described in at least one embodiment herein;
Fig. 6 depicts a flow diagram of methods of forming a shingled array of solar cells and/or methods of bonding shingled solar cells as described in at least one embodiment herein;
Fig. 7 depicts a flow diagram of methods of forming a shingled array of solar cells and/or methods of bonding shingled solar cells as described in at least one embodiment herein;
Fig. 8 is a flow diagram of a method of forming a plurality of first and second end solar cells each including an electrically conductive ribbon as described in at least one embodiment herein;
Figs. 9A and 9B each depict a flow diagram of methods of forming a shingled array of solar cells and/or methods of bonding shingled solar cells as described in at least one embodiment herein;
Figs. 10A and 10B each depict a flow diagram of methods of forming a shingled array of solar cells and/or methods of bonding shingled solar cells as described in at least one embodiment herein;
Figs. 11A and 11B are schematic views of methods of bonding intermittently as described in at least one embodiment herein;
Fig. 12A is top view of a solar module including an array of shingled solar cells and electrically conductive bus ribbons, as described in at least one embodiment herein;
Fig. 12B is a top view of an enlarged portion of the end strip solar cell including a slotted electrically conductive bus ribbon attached thereto, as depicted in Fig. 12A;
Figs. 13-15 each depict a flow diagram of methods of forming an end strip solar cell including a slotted electrically conductive bus ribbon attached thereto, as described in at least one embodiment herein.

### Detailed Description

Further details and aspects of exemplary embodiments of the present disclosure are described in more detail below with reference to the appended figures.

The present disclosure is directed to solar modules and methods of forming such solar modules which are more efficient for producing and/or conducting electrical power due to the significant and/or complete reduction in deformation of the ends of the strings and/or strips of solar cells. By reducing the deformation of the ends of the strings and strips of solar cells, the methods described herein produce flatter, more efficient solar modules which also include less, if any, cracks and/or microcracks.

The present disclosure is directed to solar modules and particularly solar modules formed from strings of shingled strips of solar cells which include electrically conductive bus ribbons added thereto prior to and/or separately from the formation of the string and/or of the shingled strips. In embodiments, the electrically conductive bus ribbon is attached to a single strip of a solar cell to form an end strip solar cell, prior to and/or separately from the formation of the rest of the string. By attaching the bus ribbon prior to and/or separately from the rest of the string and/or shingled strips, any deformation created during attachment is limited to only the end strip formed and no cracks and/or microcracks can be created in the bond between the end strip and a neighboring shingled strip because the two strips have not yet been bonded to each other.

Those of skill in the art will appreciate that in forming a solar module via the shingling process, a solar cell which is typically 156 mm X 156 mm is cut into several pieces. Depending on the solar cell, it may be 2, 3, 4, 5, 6, or more pieces that the solar cell is cut into. Each of these pieces is generally referred to as a strip. Details on this process can be found in in U.S. Patent No. 9,935,221 to Zhou et al and entitled "Shingled Array Solar Cells and Method of Manufacturing Solar Modules Including the Same," issued April 3, 2018, and incorporated herein by reference. These strips as described in the '221 Patent and as explained further herein, are adhered to one another in an overlapping and electrically connected fashion to form a string. Multiple strings are electrically joined in parallel to form a set and two or more sets may be connected in series to form the solar module.

In some embodiments, methods of forming solar modules are described which include attaching at least one electrically conductive bus ribbon to at least one strip of a solar cell to form an end strip solar cells (including the bus ribbon), prior to and/or separately from the formation of the string of shingled strips. In some embodiments, methods of forming solar modules are described which include attaching a first electrically conductive bus ribbon to a first strip of a solar cell to form a first end strip solar cell, and attaching a second electrically conductive bus ribbon to a second strip a solar cell to form a second end strip solar cell, prior to and/or separate from formation of the string of shingled strips.

The electrically conductive bus ribbons are designed and configured to carry the electric output produced by the strings of shingled strips of solar cells from one string to another neighboring string. The electrically conductive bus ribbons are commonly made from conductive metallic materials. Some examples of suitable metallic materials which efficiently conduct electricity include copper, gold, silver, tin, iron, nickel, lead, and the like. In addition, the conductive ribbons may be coated with metal alloys which will not only protect the copper but also provide better bonding to the solar cells. Some non-limiting examples of suitable metal alloys include Pb/Sn, Pb/Sn/Ag, Sn/Ag, Bi/Sn/Ag, etc.

The electrically conductive bus ribbons can be attached, i.e., fixed, secured, bonded, etc. to the strips of solar cells by any suitable method known to those skilled in the art, including but not limited to the use of electrically conductive adhesives (ECAs) and/or the use of solders. Some non-limiting examples of suitable ECAs include acrylic based ECA, epoxy based ECA, and silicone based ECA In some embodiments, the bus ribbon can be attached to the strip of solar cells to form an end strip of solar cells via soldering. In some embodiments, the bus ribbon can be attached to the strip of solar cells to form an end strip of solar cells via an ECA.

Once the end strip(s) solar cell is formed, i.e., the bus ribbon is attached electrically to a strip of a solar cells, any number of middle strips of solar cells can be connected to at least one end strip in a shingled configuration. In some embodiments, the middle strips of solar cells are positioned between two end strips of solar cells. In some embodiments, a plurality of middle strips are connected to each other in a shingled configuration prior to the addition of a first end strip on one end of the middle strips and a second end strip on a second opposite end of the middle strips. The middle strips of solar cells, unlike end strips of solar cells, are not attached directly to the bus ribbon.

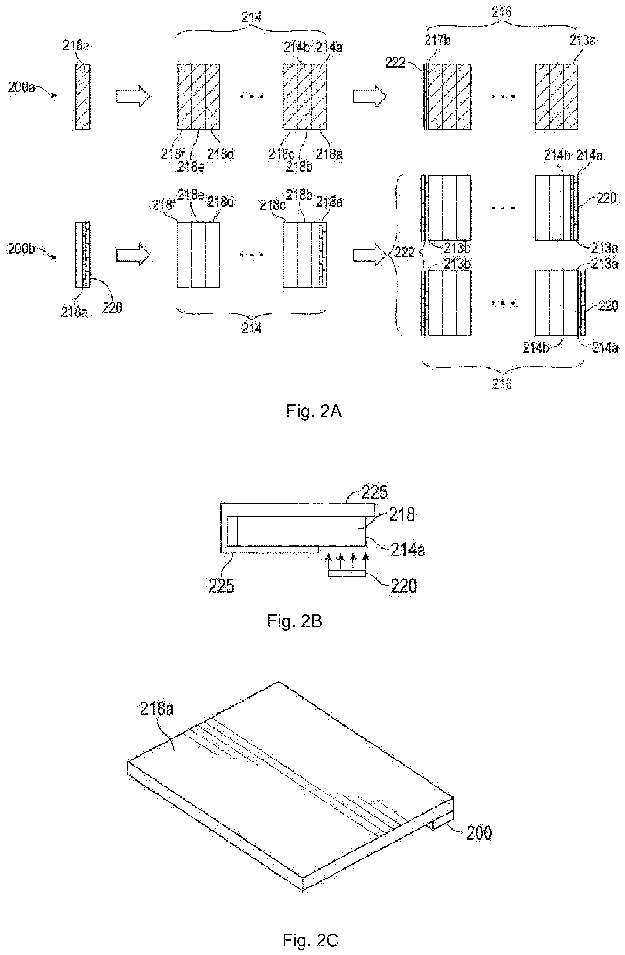

Turning now to the Figures, Figs. 2-11 of the present disclosure depict various methods described herein which are cost efficient, can be mass produced more easily, and are less labor intensive for forming modules and/or strings of shingled strips of solar cells. In addition, the modules and/or strings of shingled strips of solar cells produced are not deformed, i.e., bent or bowed, and/or include electrically conductive bus ribbons which produce less cracks and/or microcracks to the cells following attachment.

As depicted in Fig. 2A, in some embodiments, methods described herein for forming a shingled array of solar cells and/or methods of bonding shingled solar cells may include joining an electrically conductive bus ribbon 220 to a strip of a solar cells to form a first end strip solar cell 218a. The bus ribbon 220 being attached to the strip of a solar cell prior to and/or separate from the formation of a shingled configuration 214 of strips of a solar cell. The conductive ribbon 220 being affixed to the strip of a solar cells prior to the first end solar cell 218a being combined with any additional solar cells and/or prior to the formation of a string 216 of strips 218b-f of solar cells.

A top view 200a and a bottom view 200b of such methods are illustrated in Fig 2A, wherein at least one middle strip 218b-218f of solar cells (e.g., strips of solar cells without an electrically conductive bus ribbon attached thereto) is connected to first end solar cell 218a including first electrically conductive ribbon 220. As illustrated in bottom view 200b, first electrically conductive ribbon 220 is positioned on a back side of first end strip 218a solar cell and also on a first distal end portion 214a of first end strip 218a solar cell. At least the first middle strip solar cell 218b is connected, adhered, and/or soldered to a top side of a second proximal end portion 214b of first end strip 218a solar cell in a shingled manner. Any additional middle strips 218c-218f of solar cells are subsequently connected to neighboring middle strip of solar cells in a shingled manner (the series of dots is intended to represent that the string may include any number of middle strips of solar cells positioned between the first end strip 218a solar cells and the second end strip solar cell). Each of the strips of solar cells described herein are electrically connected (adhered, soldered, and/or tabbed ribbon between neighboring strips) to neighboring strips of solar cells in a shingled manner and as known to those of ordinary skill in the art.

A second electrically conductive ribbon 222 is added to a second proximal end portion 217b of the last middle strip of solar cells 218f to form a second end strip 218g solar cell. The string 216 of strips 218a-e, 218g solar cells extend in a shingled manner from the first end strip 218a of solar cells to the second end strip of solar cells 218g, a first conductive ribbon 220 secured to a first distal end portion 213a of the string 216 and a second conductive ribbon 222 on a second proximal end portion 213b of the string 216.

As can be seen from top view 200a of Fig. 2A, in some embodiments, the first electrically conductive ribbon 220 is not visible from a top view because the first electrically conductive ribbon 220 is connected, and specifically soldered, to a back side of first end strip 218a solar cell and does not protrude beyond the first distal end portion 214a of the first end strip 218a solar cell. However, in some embodiments, as shown in bottom view 200b of Fig. 2, the first electrically conductive ribbon 220 may in some instances protrude beyond the first distal end portion 214a of the first end strip 218a solar cell and may be visible from a bottom view and/or a top view.

In some embodiments, as shown in Fig. 2B, a straightening fixture 225 can be positioned on at least one side, if not both sides, of strip 218, prior to and/or during attachment of the bus ribbon 220 to the strip 218, to limit and/or prevent the strip 218 from deforming. Straightening fixture 225 is configured and designed to display sufficient rigidity and/or apply sufficient force against the strip 218 of solar cells to prevent strip 218 from bending, bowing, and/or deforming in any manner during the process of connecting the bus ribbon 220 to the strip 218 to form an end strip 218a.

In some embodiments, as shown specifically in Fig. 2B, the straightening fixture 225 may be a press designed to apply a sufficient amount of force to the solar cells and/or strips of solar cells during the process of attaching the bus ribbon to the strip to limit and/or prevent deformation of the strip.

In some embodiments, the straightening fixtures described herein may be a single sheet of material capable of maintaining a stiffness greater than the solar cells and/or strips of solar cells during the process of attaching the bus ribbon to the strip. For example, the straightening fixture may be made of a metallic material such as iron and/or stainless steel which can withstand the higher temperatures commonly associated with soldering and/or adhering of the bus ribbon to the strip. In some embodiments, the single sheet may be secured to the strip of solar cells using a fastener such as a vise and/or clamp or any other device capable of applying force to both the strip and the fixture.

In some embodiments, the straightening fixture may be made to a pre-curved surface which pushes the solar cell strip to a curved shape which will become flat after the cool down of the bonding between ribbon and end strips which first were exposed to high temperature to form a bonding.

As depicted in Fig. 2C, the addition of bus ribbon 220 to strip 218, prior to and/or separate from the formation of the string and/or shingled strips produces an end strip which is flatter and does not cause cracks and/or microcracks in the bond between neighboring middle strips of solar cells because the bond does not yet exist.

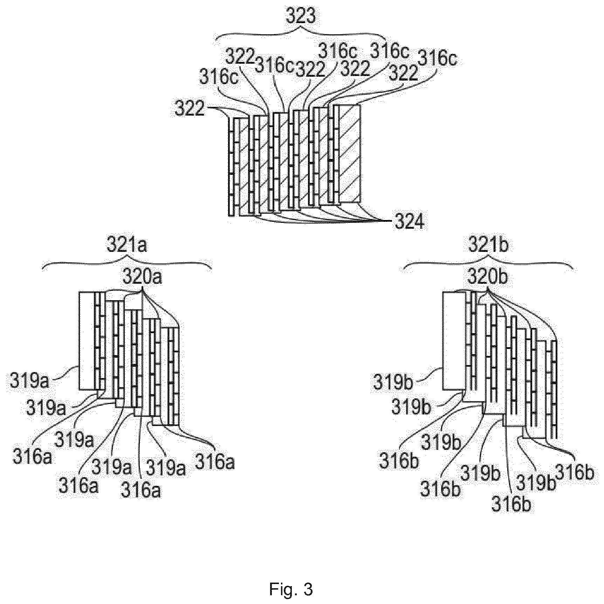

As illustrated in Figs. 3-5, in some embodiments, the methods described herein may include forming at least one, if not a plurality of, first end strip(s) of solar cells (including a first electrically conductive bus ribbon) prior to connecting any strip(s) of solar cells to each other in a shingled configuration. As further illustrated in Figs. 3-5, in some embodiments, the methods described herein may include forming at least one, if not a plurality of, second end strip(s) of solar cells (including a second electrically conductive bus ribbon) prior to connecting any strip(s) of solar cells to each other in a shingled configuration.

In some embodiments, the methods described herein may be suitable for large scale production which may require the pre-production of a plurality of first end strips of solar cells, each first end strip including a strip of solar cells joined on an end portion thereof to a first electrically conductive bus ribbon, and/or a plurality of second end strips of solar cells, each second end strip including a strip of solar cells joined on an end portion thereof to a second electrically conductive bus ribbon. By pre-production, the plurality of end strips is formed prior to being shingled and/or connected to any additional strip(s) of solar cells in any configuration, and specifically a shingled configuration. Placement of the first and second electrically conductive bus ribbons on the first and/or second end strips of solar cells may vary, including a back side or top side (sunny side) of a given end strip of solar cells and/or in a manner which may or may not protrude from an end portion of a given end strip of solar cells.

In Fig. 3, a plurality of first end strips 321a, 321b of solar cells are shown. Each first end strip 321a, 321b includes a first electrically conductive bus ribbon 320a, 320b, respectively, affixed to an end portion 316a, 316b of a solar cell 319a, 319b, respectively. The first electrically conductive ribbons 320a are depicted on a back side of solar cell 319a without protruding beyond an edge of the first end strip 321a of solar cells. The first electrically conductive ribbons 320b are depicted on a back side of solar cell 319b protruding beyond an edge of the first end strip 321b of solar cell.

Fig. 3 also shows at least one second end strip 323 of solar cells including a second electrically conductive bus ribbon 322 affixed to an end portion 316c of a solar cell 324. Second end strips 323 of solar cell are shown including second electrically conductive bus ribbon 322 positioned on solar cell 324 protruding beyond an edge of the second end strip 323 of solar cells.

The pre-production of end strips of solar cells, as depicted in Fig. 3, may in some embodiments include the use of a straightening fixture as described herein. In some embodiments, the pre-production of end strips, as depicted in Fig. 3, may not include the use of a straightening fixture.

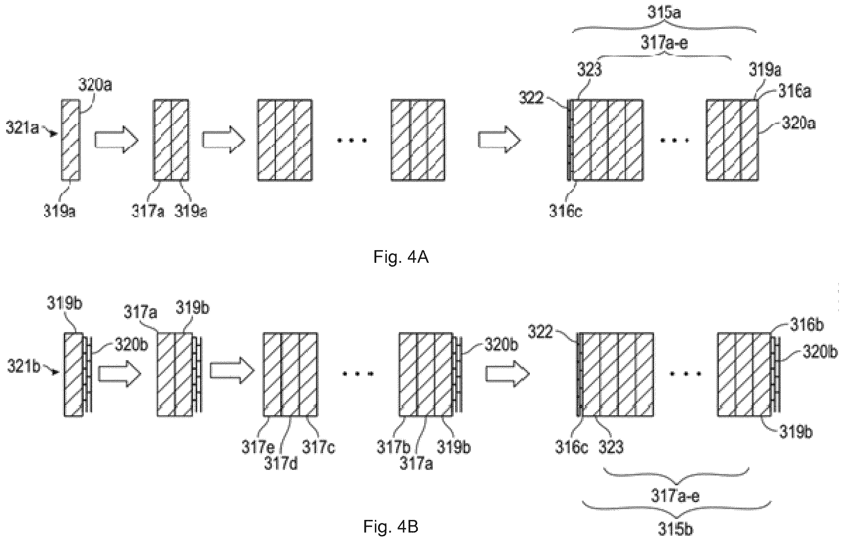

In some embodiments, as depicted in Figs. 4A and 4B for example, methods described herein for forming a shingled array of solar cells and/or methods of bonding shingled solar cells may include starting with and/or initially providing a first end solar cell 321a, 321b including an electrically conductive ribbon 320a, 320b. In Fig. 4A, first electrically conductive ribbon 320a is secured to a back side of solar cell 319a to form first end solar cell 321a, wherein first electrically conductive ribbon 320a is not visible from a top view of first end solar cell 321a. In Fig. 4B, first electrically conductive ribbon 320b is secured to a back side of solar cell 319b to form first end solar cell 321b, wherein first electrically conductive ribbon 320b is visible from a top view of first end solar cell 321b.

As depicted in Figs. 4A and 4B, following the formation of at least one of the first and/or second end strip 321a, 321b, 323, the methods described herein may further include the steps of connecting at least one middle strip 317a-317e of solar cells to a first end strip 321a, 321b solar cell. At least a first middle strip 317a of solar cells is connected, (e.g., adhered, tabbed, and/or soldered) to a top side of a second proximal end portion 316d, 316e of the first end strip 321a, 321b solar cells in a shingled manner. Any additional middle strips 317b-317e of solar cells are subsequently connected to a neighboring middle strip of solar cells in a shingled manner (the series of dots is intended to represent that the string may include any number of middle strips of solar cells positioned between the first end strip 321a, 321b solar cells and the second end strip 323 solar cells). Each of the middle strips of solar cells described herein are electrically connected (adhered, tabbed, and/or soldered) to neighboring strips of solar cells in a shingled manner as known to those of ordinary skill in the art.

As further depicted in Figs. 4A and 4B, second end strip 323 solar cells is connected to the last middle strip 317e solar cells with second conductive bus ribbon 322 extending from a proximal end portion 316c of second end strips 323 of solar cells and/or string 315a, 315b. The strings 315a, 315b are illustrated to include a combination of strips of solar cells 317a-e, 319a, 319b, 324 extending in a shingled manner from the first end strips 321a, 321b solar cells to the second end strips 323 solar cells and including a first conductive bus ribbon 320 on a first distal end portion 316a, 316b of the string 315a, 315b and a second conductive bus ribbon 322 on a second proximal end portion 316c of the string 315a, 315b.

As can be seen from Fig. 4A, in some embodiments, the first electrically conductive bus ribbon 320a is not visible from a top view because the first electrically conductive bus ribbon 320a is connected, and specifically soldered, to a back side of first end strip 321a of solar cells and does not protrude beyond a first distal end portion 316a of the first end strip 321a of solar cells. However, in some embodiments, as shown in Fig. 4B, the first electrically conductive bus ribbon 320b may protrude beyond a first distal end portion 316b of the first end strip 321b of solar cells and may be visible from a bottom view and/or a top view of the string 315b.

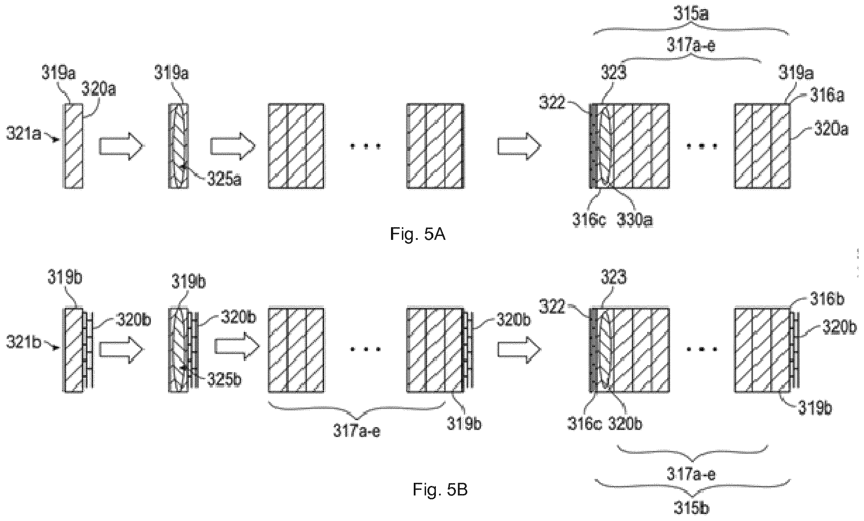

In some embodiments, as depicted in Figs. 5A and 5B for example, methods described herein for forming a shingled array of solar cells and/or methods of bonding shingled solar cells may include starting with and/or initially providing a first end strip 321a, 321b of solar cells including an electrically conductive bus ribbon 320a, 320b. In Fig. 5A, first electrically conductive bus ribbon 320a is secured to a back side of a strip of solar cells 319a to form first end strip 321a solar cell, wherein first electrically conductive bus ribbon 320a is not visible from a top view of first end strip solar cell 321a. In Fig. 5B, first electrically conductive bus ribbon 320b is secured to a front side of strip of solar cells 319b to form first end strip 321b solar cells, wherein first electrically conductive bus ribbon 320b is visible from a top view of first end strip 321b of solar cells.

As depicted in Figs. 5A and 5B, following the formation of at least one of the first and/or second end strip 321a, 321b, 323, of solar cells, the methods described herein may include in some embodiments, the step of positioning a first straightening fixture 325a, 325b on at least one side, specifically as shown on at least the top side (sunny side), of the first end strips 321a, 321b of solar cells prior to the addition and/or connection of at least one middle strip 317a-e of solar cells. First straightening fixture 325a, 325b is configured and designed to either display sufficient rigidity and/or apply sufficient force against the first end strip 2321a, 321b to prevent first end strip 321a, 321b from bending, bowing, and/or deforming in any manner during the process of connecting the first middle strip 317a to the first end strip 321a, 321b. Thus, the first straightening fixture 325a, 325b can be positioned on at least one side of the first end strip 321a, 321b at least prior to the connecting of the first middle strip 317a and remaining in position on at least one side of the first end strip 321a, 321b until at least the first middle strip 317a is electrically connected and secured to the first end strip 321a, 321b. In embodiments, the first straightening fixture 325a, 325b may be positioned on at least one side of the first end strip 321a, 321b during the entire process of forming a shingled array of solar cells. In some embodiments, the straightening fixture 325a, 325b may be removed from at least one side of the first end strip 321a, 321b prior to the connecting of the second end strip 323 and/or any of the additional middle strips 317b-e.

As further depicted in Figs. 5A and 5B, in some embodiments, the first straightening fixture 325a, 325b is removed from the first end strip 321a, 321b after connection with the first middle strip 317a in a shingled manner. Any additional middle strips 317b-317e are subsequently connected to neighboring middle strips in a shingled manner (the series of dots is intended to represent that the string may include any number of middle strips positioned between the first end strip 321a, 321b and the second end strip 323 of solar cells). Each of the middle strips described herein are electrically connected (adhered, tabbed, and/or soldered) to neighboring strips in a shingled manner as known to those of ordinary skill in the art.

As still further depicted in Figs. 5A and 5B, a second straightening fixture 330a, 330b can be positioned on at least one side, specifically as shown on at least the top side, of second end strip 323 prior to the addition and/or connection of the second end strip 323 to the last middle solar strip 317e. The second straightening fixture 330a, 330b is configured and designed to display sufficient rigidity to prevent second end strip 323 from bending, bowing, and/or deforming in any manner during the process of connecting the last middle strip 317e to the second end strip 323. Thus, the second straightening fixture 330a, 330b can be positioned on at least one side of the second end strip 323 at least prior to the connecting to the last middle strip 317e and remaining in position on at least one side of the second end strip 323 until at least the last middle strip 317e is electrically connected and secured to the second end strip 323. Second end strip 323 is connected to the last middle strip 317e with second conductive ribbon 322 extending from a proximal end portion 316c of strip 324 and/or second end strip 323 and/or string 315a, 315b. The string 315a, 315b including a combination of strips 317a-e, 319a, 319b, 324 of solar cells extending in a shingled manner from the first end strip 321a, 321b to the second end strip 323 and including a first conductive ribbon 320 on a first distal end portion 316a, 316b of the string 315a, 315b and a second conductive ribbon 322 on a second proximal end portion 316c of the string 315a, 315b.

As can be seen from Fig. 5A, in some embodiments, the first electrically conductive ribbon 320a is not visible from a top view because the first electrically conductive ribbon 320a is connected, and specifically soldered, to a back side of first end strip 321a and does not protrude beyond a first distal end portion 316a of the first end strip 321a. However, in some embodiments, as shown in Fig. 5B, in some embodiments, the first electrically conductive ribbon 320b may in some instances protrude beyond the first distal end portion 316b of the first end strip 321b and may be visible from a bottom view and/or a top view of the string 315b.

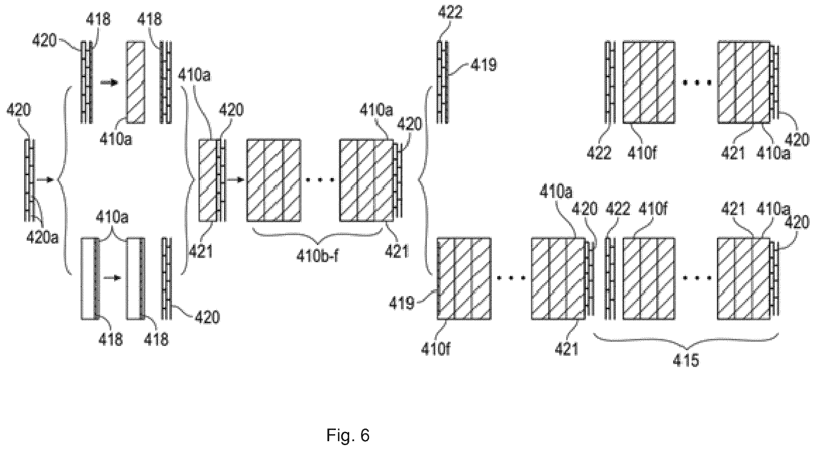

Turning now to Figs. 6-10, wherein the electrically conductive bus ribbons are joined to the strips of solar cells to form end strips of solar cells using an adhesive. Any adhesive suitable for use in solar cells manufacturing and particularly for electrically connecting and/or securing conductive ribbons to solar cells can be used. In certain embodiments, the adhesive used is an electrically conductive adhesive.

In some embodiments, as depicted in Fig. 6 for example, methods described herein for forming a shingled array of solar cells and/or methods of bonding shingled solar cells may include joining an electrically conductive bus ribbon 420 to a strip 410a of a solar cell to form a first end strip 421a solar cells prior to the formation of a string of shingled strips of solar cells. In embodiments, the conductive bus ribbon 420 is adhered to the strip 410a of a solar cell via adhesive 418 prior to the first end strip 421a solar cells being combined with any additional strips 410b-f of solar cells and/or prior to the formation of a string 415 of shingled strips of solar cells. Adhesive 418 can be applied to at least one side of conductive bus ribbon 420 and/or at least one side of strip 410a of a solar cell. Although depicted as a solid line of adhesive 418, it is envisioned that the adhesive may be applied to the conductive bus ribbon and/or the strip of solar cells in any configuration, such as a dotted, dashed, and/or discontinuous pattern.

As further depicted in Fig 6, following the formation of the first end strip 421of solar cells, i.e., the first conductive bus ribbon 420 is adhered to the strip 410a of a solar cell, at least one middle strip 410b-410f of solar cells is electrically connected to the first end strip 421 of a solar cell in a shingled array. As illustrated, first electrically conductive bus ribbon 420 is positioned on a first distal end portion 416a of first end strip 421 of a solar cell and first middle strip 410b of a solar cell is connected, adhered, tabbed, and/or soldered to a second proximal end portion 416b of first end strip 421 of a solar cell in a shingled manner. Any additional middle strips 410c-410f of solar cells are subsequently connected to a neighboring middle strip of solar cells in a shingled manner (the series of dots is intended to represent that the string may include any number of middle solar cells positioned between the first end solar cell and the second end solar cell). Each of the middle strip of solar cells described herein are electrically connected (adhered, tabbed, and/or soldered) to neighboring solar cells in a shingled manner as known to those of ordinary skill in the art.

A second electrically conductive bus ribbon 422 is adhered to a second proximal end portion 417b of the last middle strip 410f solar cell to form a second end strip 423 solar cell. A second adhesive 419 can be applied to any portion of the second conductive bus ribbon 422 and/or the last middle strip 410f of solar cells to combine the second bus ribbon 422 with the last middle strip 410f of solar cells to form second end strip 423 of solar cells. The string 415 includes a plurality of shingled strips of solar cells beginning from the first end strip 421 and extending through the middle strips to the second end strip 423, with the first conductive bus ribbon 420 on a first distal end portion 418a of the string 415 and a second conductive bus ribbon 422 on a second proximal end portion 418b of the string 415.

In some embodiments, a straightening fixture can be positioned on at least one side, or both sides, of strip 410a, prior to and/or during attachment of the bus ribbon 420 to the strip 410a, to limit and/or prevent the strip 410a from deforming.

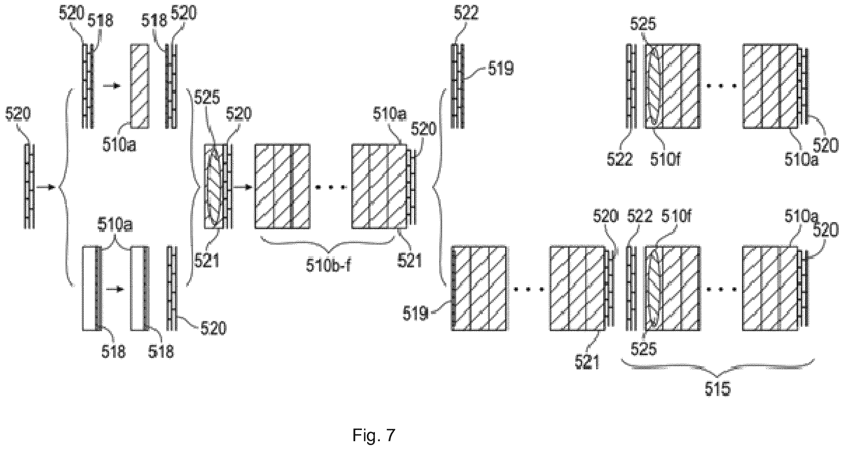

In some embodiments, as depicted in Fig. 7 for example, methods described herein for forming a shingled array of solar cells and/or methods of bonding shingled solar cells may include joining an electrically conductive bus ribbon 520 to a strip 510a of a solar cell to form a first end strip 521 solar cell prior to formation of a string of shingled solar cells. In embodiments, the conductive bus ribbon 520 is adhered to the strip 510a of a solar cell via adhesive 518 prior to the first end strip 521 being combined with any additional strips 510b-f of solar cells and/or prior to the formation of a string 515 of shingled solar cells. Adhesive 518 can be applied to at least one side of conductive bus ribbon 520 and/or at least one side of the strip 510a of a solar cell. Although depicted as a solid line of adhesive 518, it is envisioned that the adhesive may be applied to the conductive bus ribbon and/or the strips of solar cells in any configuration, such as a dotted, dashed, and/or discontinuous pattern.

As further depicted in Fig 7, following the formation of the first end strip 521 of a solar cell, i.e., the first conductive bus ribbon 520 is adhered to the strip 510a of a solar cell, a first straightening fixture 525 is positioned on at least one side of the first end strip 521, specifically as shown on at least the top side of first end strip 521 prior to the step of adding and/or connecting of the first end strip 521 to at least one middle strip 510b-f of solar cells. First straightening fixture 525 is configured and designed to display sufficient rigidity to prevent first end strip 521 from bending, bowing, and/or deforming in any manner during the process of adhering the first middle strip 510b to the first end strip 521. Thus, the first straightening fixture 525 can be positioned on at least one side of the first end strip 521 at least prior to the connecting of the first middle strip 510b and remaining in position on at least one side of the first end strip 521 until at least the first middle strip 510b is electrically connected and secured to the first end strip 521. In embodiments, the first straightening fixture 525 may be positioned on at least one side of the first end strip 521 during the entire process of forming a shingled array of solar cells. In some embodiments, the straightening fixture 525 may be removed from at least one side of the first end strip 521 prior to the connecting of the second end strip of solar cell and/or any of the additional middle strip 510b-f.

As further depicted in Fig. 7, in some embodiments, the first straightening fixture 525 is removed from the first end strip 521 after connection with the first middle strip 510b in a shingled manner. Any additional middle strips 510b-f are subsequently connected to neighboring middle strips in a shingled manner (the series of dots is intended to represent that the string may include any number of middle strips positioned between the first end strip 521 and the second end strip 523). Each of the middle strips described herein are electrically connected (adhered and/or soldered) to neighboring solar cells in a shingled manner as known to those of ordinary skill in the art

A second electrically conductive ribbon 522 is adhered to a second proximal end portion 517b of the last middle strip 510f to form a second end strip 523. A second adhesive 519 can be applied to any portion of the second conductive ribbon 522 and/or the last middle strip 510f to combine the second ribbon 522 with the last middle strip 510f to form second end strip 523. The string 515 of solar cells extending in a shingled manner from the first end strip 521 to the second end strip 523 and including a first conductive ribbon 520 on a first distal end portion 518a of the string 515 and a second conductive ribbon 522 on a second proximal end portion 518b of the string 515.

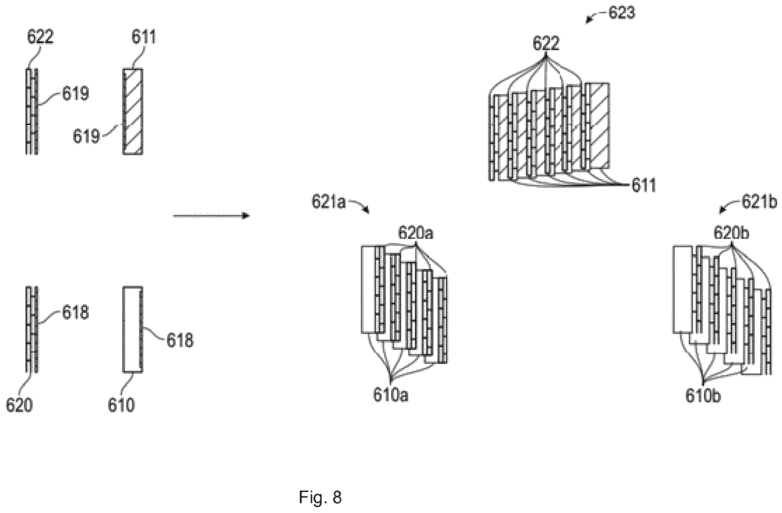

As illustrated in Figs. 8-10B, in some embodiments, the methods described herein may include forming at least one, if not a plurality of, first end strip(s) including a first electrically conductive ribbon prior to connecting any strips to each other in a shingled array. As further illustrated in Figs. 8-10B, in some embodiments, the methods described herein may include forming at least one, if not a plurality of, second end strip(s) including a second electrically conductive ribbon prior to connecting any strips to each other in a shingled array. In embodiments, the methods described herein may be suitable for large scale production which may require a plurality of first end strips each including a first electrically conductive ribbon and/or a plurality of second end strips each including a second electrically conductive ribbon prior to connecting any strips to each other in a shingled array. Placement of the first and second electrically conductive ribbon on the first and/or second end strip may vary including a back side or top side of a given end strip and/or in a manner which may or may not protrude from an end portion of a given end strip.

In Fig. 8, first adhesive 618 is shown applied to some portion of first conductive ribbon 620 and a first solar cell 610, and second adhesive 619 is shown applied to some portion of second conductive ribbon 622 and second solar cell 611, prior to formation of the first and/or second end strips 621a, 621b, 623 of solar cells. Fig. 8 further shows the formation of at least one first end strip 621a, 621b wherein the first electrically conductive ribbon 620a, 620b is adhered to a distal end portion 616a, 616b of a solar cell 610a, 610b. First end strips 621a include the first electrically conductive ribbon 620a adhered to a back side of solar cell 610a and not protruding beyond distal end portion 616a of the first solar cell 610a. First end strips 621b illustrate the first electrically conductive ribbon 620b adhered to a back side of solar cell 610b protruding beyond end portion 616b of the first solar cell 610b.

Fig. 8 also shows at least one second end strip 623 including a second electrically conductive ribbon 622 affixed to a proximal end portion 616c of a solar cell611. Second end strip 623 is shown including second electrically conductive ribbon 622 adhered to solar cell 624 protruding beyond end portion 616c of the second end strip 623.

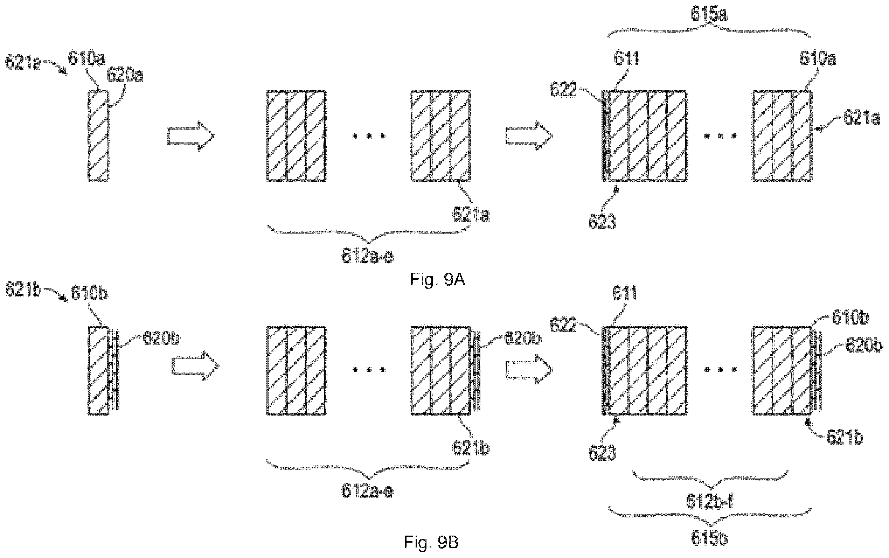

In some embodiments, as depicted in Figs. 9A and 9B for example, methods described herein for forming a shingled array of solar cells and/or methods of bonding shingled solar cells may include starting with and/or initially providing a first end strip 621a, 621b including an electrically conductive ribbon 620a, 620b. In Fig. 9A, first electrically conductive ribbon 620a is adhered via first adhesive 618 to a back side of solar cell strip 610a to form first end strip 621a, wherein first electrically conductive ribbon 620a is not visible from a top view of first end strip 621a. In Fig. 9B, first electrically conductive ribbon 620b is adhered via a second adhesive 619 to a back side of solar cells 619b to form first end strip 621b, wherein first electrically conductive ribbon 620b is visible from a top view of first end strip 621b.

As depicted in Figs 9A and 9B, and following the formation of at least one of the first and/or second end strips 621a, 621b, 623, at least one middle strip 612a-e of solar cells is connected to first end strip 621a, 621b. At least the first middle strip 612a is connected, adhered, and/or soldered to a top side of a second proximal end portion 616d, 616e of first end strip 621a, 621b in a shingled manner. Any additional middle strips 612b-612e are subsequently connected to neighboring middle strips in a shingled manner (the series of dots is intended to represent that the string may include any number of middle strips positioned between the first end strip 621a, 621b and the second end strip 623). Each of the middle strips described herein are electrically connected (adhered and/or soldered) to neighboring strips of solar cells in a shingled manner as known to those of ordinary skill in the art.

As further depicted in Figs. 9A and 9B, second end strip 623 is connected to the last middle strip 612e with second conductive ribbon 622 extending from a proximal end portion 616c of solar cell 624 and/or second end strip 623 and/or string 615a, 615b. The string 615a, 615b including a combination of solar cells 612a-e, 619a, 619b, 624 extending in a shingled manner from the first end strip 621a, 621b to the second end strip 623 and including a first conductive ribbon 620 on a first distal end portion 616a, 616b of the string 615a, 615b and a second conductive ribbon 622 on a second proximal end portion 616c of the string 615a, 615b.

As can be seen from Fig. 9A, in some embodiments, the first electrically conductive ribbon 620a is not visible from a top view because the first electrically conductive ribbon 620a is connected, and specifically adhered, to a back side of first end strip 621a and does not protrude beyond a first distal end portion 616a of the first end strip 621a. However, as shown in Fig. 9B, in some embodiments, the first electrically conductive ribbon 620b may in some instances protrude beyond the first distal end portion 616b of the first end strip 621b and may be visible from a bottom view and/or a top view of the string 615b.

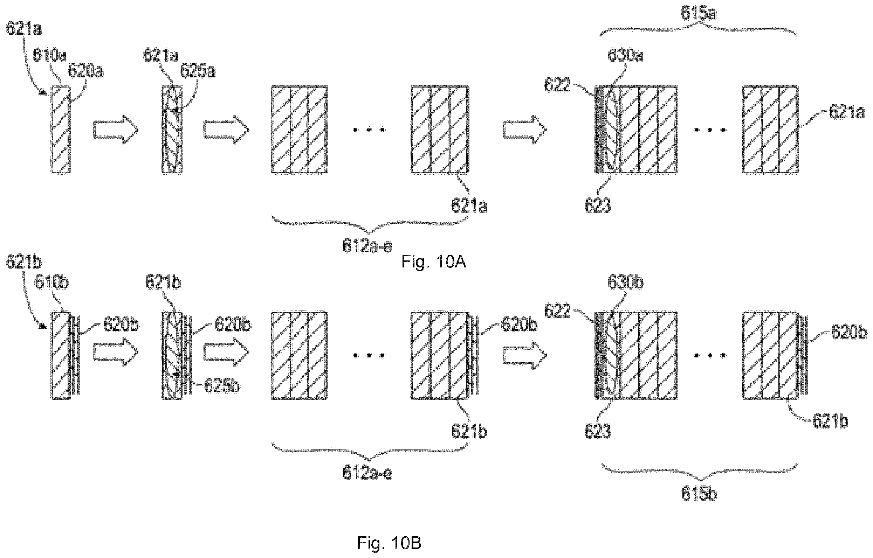

In some embodiments, as depicted in Figs. 10A and 10B for example, methods described herein for forming a shingled array of solar cells and/or methods of bonding shingled solar cells may include starting with and/or initially providing a first end strip 621a, 621b including an electrically conductive ribbon 620a, 620b adhered thereto. In Fig. 10A, first electrically conductive ribbon 620a is adhered via a first adhesive 618 to a back side of a strip of solar cells 610a to form first end strip 621a, wherein first electrically conductive ribbon 620a is not visible from a top view of first end strip 621a. In Fig. 10B, first electrically conductive ribbon 620b is adhered via a second adhesive 619 to a back side of a strip of solar cells 610b to form first end strip 621b, wherein first electrically conductive ribbon 620b is visible from a top view of first end strip 621b.

As depicted in Figs 10A and 10B, following the formation of at least one of the first and/or second end strips 621a, 621b, 623, a first straightening fixture 625a, 625b is positioned on at least one side, specifically as shown on at least the top side, of first end strip 621a, 621b prior to the addition and/or connection of at least one middle strip 612a-e. First straightening fixture 625a, 625b is configured and designed to display sufficient rigidity to prevent first end strip 621a, 621b from bending, bowing, and/or deforming in any manner during the process of connecting the first middle strip 612a to the first end strip 621a, 621b. Thus, the first straightening fixture 625a, 625b can be positioned on at least one side of the first end strip 621a, 621b at least prior to the connecting of the first middle strip 612a and remaining in position on at least one side of the first end strip 621a, 621b until at least the first middle strip 612a is electrically connected and secured to the first end strip 621a, 621b. In embodiments, the first straightening fixture 625a, 625b may be positioned on at least one side of the first end strip 621a, 621b during the entire process of forming a shingled array of strips of solar cells. In some embodiments, the straightening fixture 625a, 625b may be removed from at least one side of the first end strip 621a, 621b prior to the connecting of the second end strip 623 and/or any of the additional middle strips 612b-e.

As further depicted in Figs. 10A and 10B, in some embodiments, the first straightening fixture 625a, 625b is removed from the first end strip 621a, 621b after connection with the first middle strip 612a in a shingled manner. Any additional middle strips 612b-612e are subsequently connected to neighboring middle strip in a shingled manner (the series of dots is intended to represent that the string may include any number of middle strips positioned between the first end strip 621a, 621b and the second end strip 623). Each of the middle strips of solar cells described herein are electrically connected (adhered and/or soldered) to neighboring strips of solar cells in a shingled manner as known to those of ordinary skill in the art.

As still further depicted in Figs. 10A and 10B, a second straightening fixture 630a, 630b is positioned on at least one side, specifically as shown on at least the top side, of second end strip 623 prior to the addition and/or connection of the second end strip 623 to the last middle strip 612e. The second straightening fixture 630a, 630b is configured and designed to display sufficient rigidity to prevent second end strip 623 from bending, bowing, and/or deforming in any manner during the process of connecting the last middle strip 612e to the second end strip 623. Thus, the second straightening fixture 630a, 630b can be positioned on at least one side of the second end strip 623 at least prior to the connecting to the last middle strip 617e and remaining in position on at least one side of the second end strip 623 until at least the last middle strip 612e is electrically connected and secured to the second end strip 623. Second end strip 623 is connected to the last middle strip 612e with second conductive ribbon 622 extending from a proximal end portion 616c of second end strip 623 and/or string 615a, 615b. The string 615a, 615b including a combination of strips 612a-e, extending in a shingled manner from the first end strip 621a, 621b to the second end strip 623 and including a first conductive ribbon 620 on a first distal end portion 616a, 616b of the string 615a, 615b and a second conductive ribbon 622 on a second proximal end portion 616c of the string 615a, 615b.

As can be seen from Fig. 10A, in some embodiments, the first electrically conductive ribbon 620a is not visible from a top view because the first electrically conductive ribbon 620a is connected, and specifically soldered, to a back side of first end strip 621a and does not protrude beyond a first distal end portion 616a of the first end strip 621a. However, as shown in Fig. 10B, in some embodiments, the first electrically conductive ribbon 620b may in some instances protrude beyond the first distal end portion 616b of the first end strip 621b and may be visible from a bottom view and/or a top view of the string 615b.

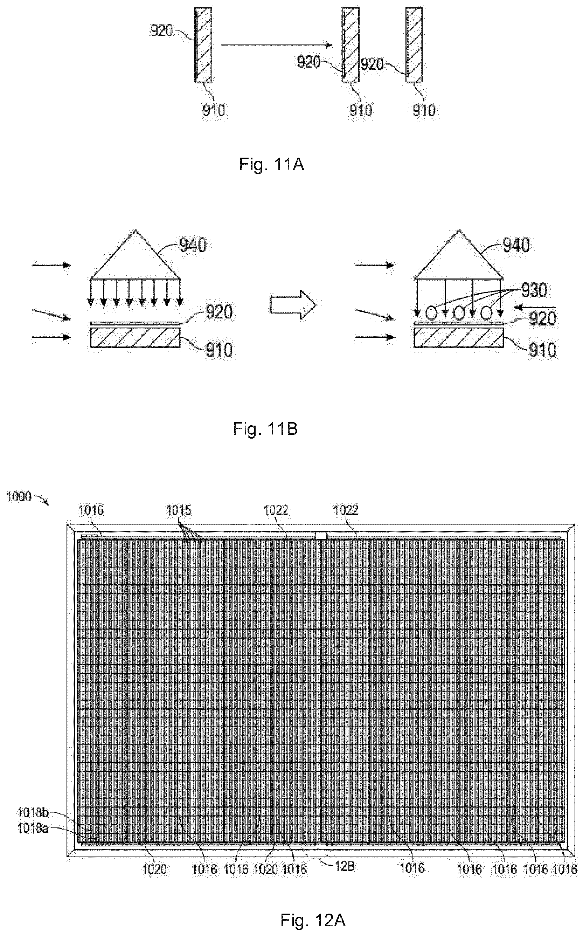

Figs. 11A and 11B illustrate an energy device 940a, 940b suitable for delivering energy, i.e., heat energy, light energy, etc., to an adhesive or solder 920 positioned on a surface of strip 910 of solar cells as described herein prior to attachment of the bus ribbon. In Fig. 11A, formation of a continuous bead or line of adhesive or solder is formed near an edge of the strip 219. In Fig. 11B, a masking device 930 is positioned between the device 940b and the adhesive or solder 920 to expose only intermittent portions of the adhesive or solder to the energy thereby forming a discontinuous pattern of adhesive or solder along a length of the strip 910 of solar cells. The masking device 930 configured to block the energy delivered by device 940b. The masking device 930 may be attached to device 940 and/or may be temporarily positioned between device 940b and adhesive/solder 920.

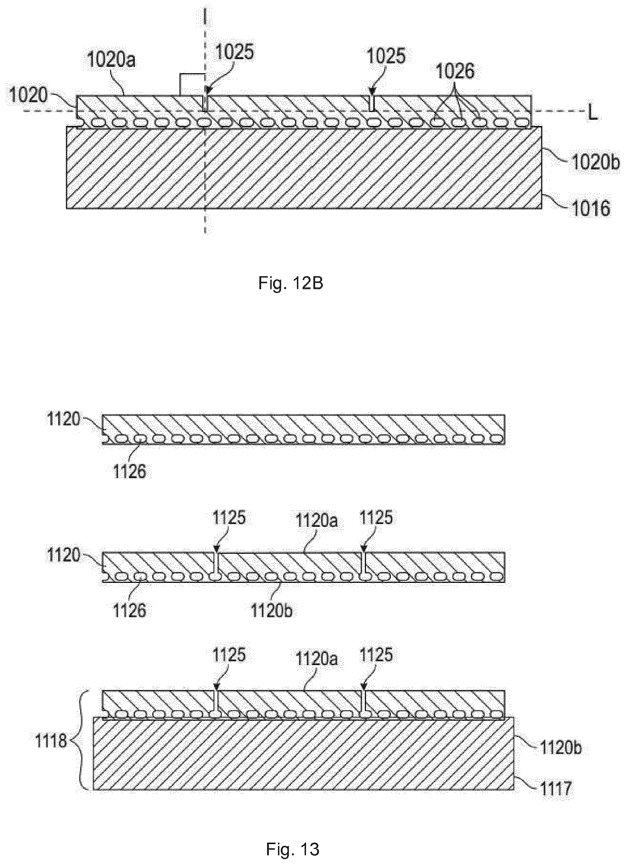

Turning now to Figs. 12-15, a solar module and methods of forming such solar modules are depicted which include a bus ribbon which is slotted to further reduce the rigidity and/or stiffness of the bus ribbons described herein. It is envisioned that by decreasing the rigidity and/or stiffness of the bus ribbon, the amount of deformation of the end strip of solar cells will also decrease because the bus ribbon will be more flexible and unable to apply a greater stiffness to the strip.

As shown in Fig. 12A, a solar module 1000 can be formed to include an array of shingled strings 1016 of solar cells 1015, each string 1016 (larger first area emphasized in bold) including a plurality of strips 1018a, 1018b (second smaller areas emphasized in bold) of solar cells 1015, each neighboring strip 1018a, 1018b of solar cells 1050 connected to each other in a shingled configuration. As further depicted in Fig. 12, each string 1016 includes an electrically conductive bus ribbon 1020, 1022 positioned on opposite end portions, i.e., proximal end portion 1014a and distal end portion 1014b, of the string 1016. The electrically conductive bus ribbons 1020, 1022 are designed to carry the electric output produced by the string(s) 1016 of shingled strips 1018a, 1018b of solar cells 1015.

Fig. 12 depicts an electrically conductive bus ribbon 1020, 1022 including at least one slot 1025. The at least one slot 1025 is a hole or void in bus ribbon 1020, 1022 which extends inwardly from a free outer edge 1020a, 1022a of bus ribbon 1020, 1022 in a direction towards a secured edge 1020b, 1022b of bus ribbon 1020, 1022. In some embodiments, a longitudinal axis 1 of the at least one slot 1025 extends generally perpendicular to a longitudinal axis L of the bus ribbon 1020, 1022. In some embodiments, the at least one slot is generally rectangular.

In some embodiments, the electrically conductive bus ribbons 1020, 1022 may include only the at least one slot 1025 and does not include any perforations. In some embodiments, the electrically conductive bus ribbons 1020, 1022 may include at least one perforation 1026 and at least one slot 1025. In some embodiments, the perforations 1026 may be generally round and/or circular and the slots 1025 may be generally rectangular. The perforation 1026 helps to release some of mechanical stress caused by the different thermal expansion coefficient of silicon and ribbon materials. In some embodiments, there may be a few rows of the perforations which further release the stress. In some embodiments, portion of the ribbon may be solid so it can block the color behind the ribbon in the background. In this case, the slot 1025 will help to release the stress in the solid part of the ribbon.

In some embodiments, as illustrated in Fig. 13, the bus ribbon 1120 initially can be formed, with or without perforations 1126, and slots 1125 can be added to bus ribbon 1120 prior to being attached to a strip 1117 of solar cells thereby forming an end strip 1118 of solar cells. As specifically shown, in some embodiments, bus ribbon 1120 may include a single row of perforations 1126 positioned along a first edge 1120b secured to strip 1117 and slots 1125 intermittently positioned along free edge 1120a.

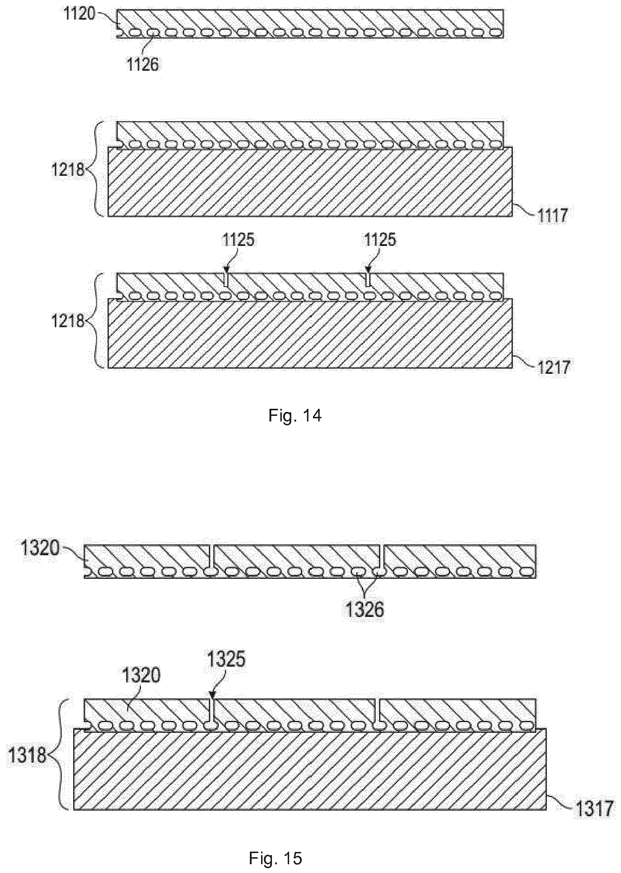

In some embodiments, as illustrated in Fig. 14, the bus ribbon 1220 can be formed, with or without perforations 1226, and slots 1225 can be added to the bus ribbon 1220 after being attached to a strip 1217 of solar cells thereby forming an end strip 1218 of solar cells. In still other embodiments, as illustrated in Fig. 15, the bus ribbon 1320 can be preformed to include both perforations 1326 and slots 1325 prior to being attached to a strip 1317 of solar cells thereby forming an end strip 1318 of solar cells.

The slots and/or the perforations can be formed in the electrically conductive bus ribbons using any suitable method. In embodiments, the slots and/or perforations can be formed via a punching process. The process of punching or removal of some portion of the conductive bus ribbon to form the slots and/or perforations can be performed in several ways, such as mechanical punching processes and/or laser cutting processes. In some embodiments, the slots and perforations may be formed using the same process, i.e., created with a punch. In some embodiments, the slots and perforations may be formed using different processes, i.e., the slots may be created by a laser cutting process and the perforations may be created with a punch.

The addition of the slots to the bus ribbon along the free outer edge may decrease deformation of the strip of solar cells. In some embodiments, the slots decrease deformation of the strip of cells by more than about 50% as compared to strips of solar cells which do not include slots. In some embodiments, the slots decrease deformation of the strip of cells by more than about 65% as compared to strips of solar cells which do not include slots. In some embodiments, the slots decrease deformation of the strip of cells by more than about 80% as compared to strips of solar cells which do not include slots. As noted above, when heated during the soldering process the silicon of the solar cell and the metal of the ribbon expand at different rates and because they have different coefficients of expansion and have significantly different masses. The formation of the slots helps release the tension created in the joined components caused by the cooling of the soldered connection between the ribbon and the strip of solar cell. The perforations also assist with release of the tensions created during the heating and cooling cycles. The result is that a strip of a solar cell soldered to a ribbon having slots and /or perforations experiences significantly less cupping and deformation and can be more easily bonded to other strips, as outlined herein, to form a solid electrical connection and an efficient solar module.

While several embodiments of the disclosure have been shown in the drawings, it is not intended that the disclosure be limited thereto, as it is intended that the disclosure be as broad in scope as the art will allow and that the specification be read likewise. Any combination of the above embodiments is also envisioned and is within the scope of the appended claims. Therefore, the above description should not be construed as limiting, but merely as exemplifications of particular embodiments. Those skilled in the art will envision other modifications within the scope of the claims appended hereto.

## Claims

1. A method of forming a shingled array of strips of solar cells comprising the steps of:
a) attaching a first electrically conductive bus ribbon to a first strip of a solar cell to form a first end strip solar cell,
b) connecting at least one middle strip to the first end strip solar cell in a shingled configuration,
c) connecting a second strip to the at least one middle strip to form a string of shingled strips,
d) attaching a second electrically conductive bus ribbon to the second strip to form a second end strip solar cell.

2. The method of claim 1, wherein attaching of step a) includes
- soldering of the first electrically conductive bus ribbon to the first strip; and/or
- adhering of the first electrically conductive bus ribbon to the first strip via an adhesive.

3. The method according to any of the preceding claims, wherein the first electrically conductive bus ribbon of step a) is attached to a back side of the first strip.

4. The method of claim 3, wherein the first electrically conductive bus ribbon
a) is visible from a top side of the string of shingled strips; or
b) is not visible from a top side of the string of shingled strips..

5. The method according to any of the preceding claims, wherein attaching of step d) includes
- soldering of the second electrically conductive bus ribbon to the second strip; and/or
- adhering of the second electrically conductive bus ribbon to the second strip via adhesive.

6. The method according to any of the preceding claims, wherein the second electrically conductive bus ribbon is visible from a top side of the string of shingled strips.

7. The method according to any of the preceding claims, further comprising positioning a first straightening fixture on at least one side of the first strip prior to step a) to prevent deformation of the first strip or the first electrically conductive bus ribbon during step a).

8. The method according to any of the preceding claims, further comprising positioning a first straightening fixture on at least one side of the first end strip solar cell, preferably on a top side of the first end strip solar cell, prior to step b) to prevent deformation of at least one of the first end strip solar cell or the first electrically conductive bus ribbon during step b).

9. A method of forming a shingled array of solar cells comprising the steps of:
a) attaching a first electrically conductive bus ribbon to a distal end portion of a first strip of a solar cell to form a first end strip solar cell,
b) attaching a second electrically conductive bus ribbon to a proximal end portion of a second strip of solar cells to form a second end strip solar cell,
c) connecting at least one middle strip to a proximal end portion of the first end strip solar cell in a shingled configuration,
d) connecting a distal end portion of the second end strip solar cell to the at least one middle strip to form a string of shingled strips.

10. The method of claim 9, wherein attaching of step a) includes
- soldering of the first electrically conductive bus ribbon to the first strip; and/or
- adhering of the first electrically conductive bus ribbon to the first strip via an adhesive.

11. The method of claim 9 or 10, wherein the first electrically conductive bus ribbon
a) is visible from a top side of the string of shingled strips; or
b) is not visible from a top side of the string of shingled strips.

12. The method according to any of the claims 9 to 11, wherein attaching of step b) includes
- soldering of the second electrically conductive bus ribbon to the second strip; and/or
- adhering of the second electrically conductive bus ribbon to the second strip via adhesive.

13. The method according to any of the claims 9 to 12, wherein the second electrically conductive bus ribbon is visible from a top side of the string of shingled strips.

14. The method according to any of the claims 9 to 13, further comprising positioning a first straightening fixture on at least one side of the first end strip solar cell, preferably on a top side of the first end strip solar cell, prior to step c) to prevent deformation of at least one of the first end strip solar cell or the first electrically conductive bus ribbon during step c).

15. The method according to any of the claims 9 to 14, further comprising positioning a second straightening fixture on a top side of the second end strip solar cell, and preferably further on a bottom side of the second end strip solar cell, prior to step d) to prevent deformation of at least one of the second end strip solar cell or the second electrically conductive bus ribbon during step d).

16. A solar module including,
at least one string including an array of shingled strips of solar cells and
at least one first electrically conductive bus ribbon having a secured edge which is connected to a first end of the string and a free outer edge including slots, the slots extending inwardly from the free outer edge in a direction towards the secured edge.

17. The solar module of claim 16, wherein the slots include a longitudinal axis which is generally perpendicular to a longitudinal axis of the bus ribbon.

18. The solar module of claim 16 or 17, wherein the first conductive bus ribbon further include perforations positioned along the secured edge of the bus ribbon, wherein preferably the perforations are different shape than the slots.

19. The solar module according to any of the claims 16 to 18, further comprising at least one second electrically conductive bus ribbon having a secured edge which is connected to a second end of the string and a free outer edge including slots, the slots extending inwardly from the free outer edge in a direction towards the secured edge of the second bus ribbon.

20. A method of forming a shingled array of strips of solar cells comprising the steps of:
a) attaching a first edge of a first electrically conductive bus ribbon to a first strip of a solar cell to form a first end strip solar cell, wherein a free outer edge of the first electrically conductive bus ribbon includes slots extending inwardly from the free outer edge in a direction towards the first edge of the first electrically conductive bus ribbon
b) connecting at least one middle strip to the first end strip solar cell in a shingled configuration,
c) connecting a second strip to the at least one middle strip to form a string of shingled strips,
d) attaching a second electrically conductive bus ribbon to the second strip to form a second end strip solar cell.

21. The method of claim 20 wherein the slots are added to the first electrically conductive bus ribbon prior to attaching of the first electrically conductive bus ribbon of step a) or after attaching of the first electrically conductive bus ribbon of step a).
